Europäisches Patentamt

European Patent Office

Office européen des brevets

(11) Veröffentlichungsnummer : **0 017 251
B1**

(12) **EUROPÄISCHE PATENTSCHRIFT**

(45) Veröffentlichungstag der Patentschrift :
**15.12.82**

(21) Anmeldenummer : **80101870.6**

(22) Anmeldetag : **08.04.80**

(51) Int. Cl.³ : **G 01 R 23/02, G 04 F 10/04**

(54) Schaltungsanordnung für die Bestimmung der mittleren Periodendauer eines periodischen Signals.

(30) Priorität : **07.04.79 DE 2914072**

(43) Veröffentlichungstag der Anmeldung :
**15.10.80 (Patentblatt 80/21)**

(45) Bekanntmachung des Hinweises auf die Patenterteilung : **15.12.82 Patentblatt 82/50**

(84) Benannte Vertragsstaaten :
**AT BE CH FR GB IT LI NL SE**

(56) Entgegenhaltungen :
**US A 3 508 034
US A 3 656 060
US A 3 739 163**

(73) Patentinhaber : **Kernforschungsanlage Jülich Gesellschaft mit beschränkter Haftung
Postfach 1913
D-5170 Jülich (DE)**

(72) Erfinder : **Fremerey, Johan K., Dr.
Mönkemöllerstrasse 19
D-5300 Bonn 1 (DE)**

**Schaltungsanordnung für die Bestimmung der mittleren Periodendauer eines periodischen Signals**

Die Erfindung bezieht sich auf eine Schaltungsanordnung für die Bestimmung der mittleren Periodendauer eines periodischen Signals, insbesondere eines elektrischen Signals, mit einer im Takt des periodischen Signals freigegebenen oder gestoppten Zählvorrichtung zur Bildung von Impulssummen, wobei die Impulse aus einem frequenzstabilen Zeittaktgenerator stammen.

In der modernen Meßtechnik ist es vielfach erforderlich, die mittlere Periodendauer von periodischen Signalen und damit auch deren zeitliche Änderungen möglichst exakt zu bestimmten. So wird beispielsweise bei bekannten Geräten das Frequenzauflösungsvermögen für niederfrequente periodische Signale dadurch verbessert, daß an Stelle der direkten Frequenzmessung zunächst die Periodendauer des Signals ausgemessen und anschließend in die entsprechende Frequenz umgerechnet wird. Die Messung der Periodendauer geschieht dabei mittels der Impulse eines Hochfrequenzgenerators, so daß an der Zählvorrichtung eine sehr viel höhere Impulsrate ansteht als bei der direkten Frequenzmessung, bei der nur die Impulsrate der zu messenden Frequenz zur Verfügung steht. So läßt sich beispielsweise die Frequenz eines 10 Hz — Signals bei direkter Frequenzmessung innerhalb einer Sekunde nur auf 10 % genau bestimmen, da die letzte Stelle des Zählers grundsätzlich eine Unsicherheit von 1 hat. Wenn man aber die Periodendauer des gleichen Signals mittels eines Mikrosekunden-Zeittaktgenerators (1 MHz — Oszillator) ausmißt, so erhält man innerhalb einer Zehntelsekunde 100 000 Impulse. Unter Berücksichtigung der Unsicherheit der letzten Stelle ergibt sich dann bei zehnfach verkürzter Meßzeit eine Meßgenauigkeit von 0.001 % für dasselbe Signal.

Eine derart hohe Meßgenauigkeit wird aber in der Praxis bei weitem nicht erreicht, wenn das zu messende Signal etwa als sinusförmige Spannung vorliegt. Der Grund hierfür liegt in der zeitlichen Unbestimmtheit der Anfangs- und Endpunkte der mittels des Zeittaktgenerators auszumessenden Perioden. Die zeitliche Unbestimmtheit dieser für die Periodendauermessung herangezogenen Punkte, etwa der Nulldurchgänge des Sinussignals, kann mittels eines Oszillografen dargestellt werden. Sie ist an einem mehr oder weniger deutlichen Zittern des Oszillografenbildes in Richtung der Zeitachse erkennbar und ist dementsprechend auch unter der englischsprachigen Bezeichnung « Jitter » bekannt. Der Jitter ist sehr oft eine statistische Größe, die von nichtharmonischen Störspannungen herrührt. Bei einem Störspannungsabstand von 40 dB, wie er z.B. in Telemetriesystemen üblich ist, muß mit einem Jitter von der Größenordnung 0.1 % der Periodendauer gerechnet werden. Dieser Fehler ist bereits 100-mal so groß wie die oben angegebene Meßgenauigkeit.

Es sind Vorrichtungen bekannt, bei denen die Auswirkung des Jitterfehlers auf die Meßgenauigkeit der Frequenz von störspannungsbehafteten periodischen Signalen um mehrere Größenordnungen reduziert werden kann. Diese Vorrichtungen basieren auf der Methode der Vielfachperiodenmessung, d.h. darauf, daß eine Vielzahl von aufeinanderfolgenden Perioden des zu untersuchenden Signals gemessen wird. Die Messung erfolgt in der Weise, daß der hochfrequente Zeittaktgenerator z.B. im Zeitpunkt des Nulldurchgangs des zu messenden Signals eingeschaltet und nicht schon beim übernächsten Nulldurchgang, d.h. nach einer Periode, sondern erst nach Ablauf von beispielsweise 100 Perioden wieder abgeschaltet wird. Das Ergebnis stellt dann die 100 fache Periodenlänge dar. Eine automatische Division durch 100 liefert die gemittelte Zeitdauer einer Periode. Da der absolute Jitterfehler bei der bekannten Vielfachperiodenmessung ebenso groß ist wie bei der Einfachperiodenmessung, ergibt sich aufgrund der Division durch 100 ein 100-mal kleinerer Jitterfehler bezogen auf eine Einzelperiode des zu messenden Signals.

Dem Vorteil der erhöhten Meßgenauigkeit steht jedoch bei den bekannten Vorrichtungen der Nachteil eines erhöhten Zeitaufwandes entgegen. Die Meßzeit in dem oben genannten Beispiel beträgt 10 Sekunden. Wenn, was in der niederfrequenten Meßtechnik häufig der Fall ist, das zu messende Signal mit höheren Störspannungen belegt ist, können durchaus mehr als 100 Sekunden zur Erzielung der eingangs genannten Meßgenauigkeit erforderlich werden. Die bekannten Vorrichtungen sind deshalb beispielsweise zur Drehzahlüberwachung nur beschränkt geeignet. Eine Erhöhung der Meßgenauigkeit ist nur noch mittels selektiver Vorrichtungen möglich, die den Jitterfehler vor der Eingabe in die Zählvorrichtung entsprechend reduzieren. Selektive Vorrichtungen haben aber naturgemäß den Nachteil, daß sie auf einen engen Frequenzbereich beschränkt sind.

Es ist daher Aufgabe der Erfindung, eine Schaltungsanordnung zu schaffen, die es erlaubt, die mittlere Periodendauer eines periodischen Signals oder eine mit der Periodendauer in funktionaler Abhängigkeit stehende Bestimmungsgröße in kürzeren Zeitabständen als dies bei der bekannten Vielfachperiodenmessung möglich ist, zugleich aber mit der bei der bekannten Vielfachperiodenmessung erzielbaren Genauigkeit zu bestimmen. Die Schaltungsanordnung soll dabei ohne Einschränkung auf einen bestimmten Frequenzbereich einsetzbar sein.

Die der Erfindung zugrundeliegende Aufgabe wird gemäß der Erfindung gelöst durch ein über einen mit dem periodischen Signal synchronen Befehlstakt von außen steuerbares und zur Aufnahme der Impulssummen vorgesehenes Datenregister mit mindestens zwei Speicherplätzen und ein dem Datenregister nachgeschaltetes Addierwerk, welches mit den für die Bildung der Summe vorgesehenen Speicherplätzen des Datenregisters derart in elektrischer Verbindung steht, daß am Ausgang der Schaltungsanordnung jeweils die Summe aus einer vorgegebenen Anzahl von aufeinanderfolgend abgespeicherten Impulssumen zur Verfügung steht.

Die Schaltungsanordnung gemäß der Erfindung ermöglicht die Gewinnung von Resultaten mit der bei der bekannten Vielfachperiodenmessung erzielbaren Genauigkeit, jedoch in zeitlich dichterer Folge. Die zeitlich dichtere Folge wird dadurch erreicht, daß sich die gebildeten Summen entsprechend der Anzahl der von dem Summierwerk erfaßten Speicherplätze überlappen. Wird beispielsweise bei Durchführung der bekannten Vielfachperiodenmessung ein Ergebnis alle 10 Sekunden erzielt, so ist bei Verwendung der Schaltungsanordnung gemäß der Erfindung bei zehnfacher Überlappung der Vielfachperiodenmessungen bereits jede Sekunde ein Ergebnis mit derselben Genauigkeit zu gewinnen. Am Ausgang des Addierwerkes steht in diesem Falle jeweils die Summe von zehn im Datenregister aufeinanderfolgend abgespeicherten Impulssummen. Eine Division dieser Zehnfachsumme durch 10 ergibt einen Mittelwert für die Eingangs-Impulssummen, der, bezogen auf den Mittelwert, um den Faktor 10 verringert erscheint.

Da eine Division durch eine durch 10 teilbare Zahl bei Verwendung von Dezimalrechenwerken durch Kommaverschiebung, d.h. unter Verzicht auf ein Divisionsrechenwerk bewirkt werden kann, sind solche Ausführungsformen der erfindungsgemäßen Schaltungsanordnung besonderes vorteilhaft, in denen die Anzahl der durch die Summenbildung erfaßten Speicherplätze des Datenregisters durch die Zahl 10 teilbar ist.

Eine weitere vorteilhafte Ausgestaltung der erfindungsgemäßen Schaltungsanordnung besteht darin, daß das Datenregister als Schieberegister ausgebildet ist. Das nachfolgende Addierwerk kann dann mit einer vorgegebenen Anzahl von hintereinandergeschalteten Speicherplätzen in fester elektrischer Verbindung bleiben. Die Bildung einer neuen Summe erfolgt dann im Zeitpunkt der von dem mit dem periodischen Signal synchronen Befehlstakt gesteuerten gleichzeitigen Verschiebung aller gespeicherten Impulssummen um einen Speicherplatz ohne zeitaufwendige Umadressierung von Speicherplätzen.

Die Summenbildung mittels des als Bestandteil der erfindungsgemäßen Schaltungsanordnung vorgesehenen Addierwerkes kann auf unterschiedliche Weise erreicht werden. Entweder wird synchron mit dem Befehlstakt jeweils die Summe aller auf den zu berücksichtigenden Speicherplätzen des Datenregisters abgespeicherten Impulssummen erneut gebildet. Dazu muß das Addierwerk dann mindestens kurzzeitig mit sämtlichen für die Summenbildung vorgesehenen Speicherplätzen elektrisch verbunden sein. Oder es wird zunächst jeweils die Differenz zwischen den im ersten und letzten der zu berücksichtigen Speicherplätze abgespeicherten Impulssummen gebildet, die dann mittels des Addierwerkes aufsummiert werden. Der Vorteil der letztgenannten Methode zur Summenbildung besteht darin, daß das Datenregister bei einer beliebigen Anzahl von dazwischenliegenden Speicherplätzen ausgangsseitig nur mit den zwei für die Differenzbildung vorgesehenen Speicherplätzen angekoppelt zu werden braucht. Dies erlaubt insbesondere den Einsatz von handelsüblichen vielstufigen Schieberegistern, bei denen die Ausgänge der inneren Speicherplätze nicht herausgeführt sind. In einer weiteren vorteilhaften Ausgestaltung der erfindungsgemäßen Schaltungsanordnung wird deshalb zwischen Datenregister und Addierwerk ein Subtrahierwerk eingeschaltet.

Eine vorteilhafte Ausgestaltung der Schaltungsanordnung gemäß der Erfindung besteht ferner darin, daß dem Addierwerk ein zweites Datenregister nachgeschaltet ist mit mindestens drei Speicherplätzen und ein dem zweiten Datenregister nachgeschaltetes Subtrahierwerk, welches mit dem zweiten Datenregister derart in elektrischer Verbindung steht, daß am Ausgang des Subtrahierwerkes jeweils die Differenz zweier nicht aufeinanderfolgend abgespeicherter Summen ansteht. Dabei kann es zweckmäßig sein, daß das zweite Datenregister als Schieberegister ausgebildet ist, und das Subtrahierwerk mit den für die Bildung der Differenz vorgesehenen Speicherplätzen in elektrischer Verbindung steht. Außerdem kann es zweckmäßig sein, daß die Anzahl der Speicherplätze des zweiten Schieberegisters $Z = N + 1$ ist, wobei $N$ durch die Zahl 10 teilbar ist, und daß das Subtrahierwerk mit dem zweiten Schieberegister derart verbunden ist, daß es $N-1$ Speicherplätze überbrückt.

Die vorgenannte Weiterausgestaltung der erfindungsgemäßen Schaltungsanordnung ermöglicht die Bestimmung der zeitlichen Änderung der mittleren Periodendauer des periodischen Signals, wobei auch die dieser Änderung entsprechenden Meßwerte am Ausgang des Subtrahierwerkes in einer gegenüber den bekannten Schaltungen entsprechend dem Überlappungsfaktor verkürzten zeitlichen Folge ausgegeben werden. Die zeitliche Änderung der mittleren Periodendauer kann in vorteilhafter Weise insbesondere zur Stabilisierung der mittleren Periodendauer des periodischen Signals oder einer mit der mittleren Periodendauer in funktionaler Abhängigkeit stehenden Bestimmungsgröße herangezogen werden.

Eine weitere vorteilhafte Ausgestaltung der erfindungsgemäßen Schaltungsanordnung besteht darin, daß zwischen dem Addierwerk und dem zweiten Datenregister mindestens ein weiteres Datenregister mit Addierwerk vorgesehen ist. Dabei bietet die Erweiterung der efindungsgemäßen Schaltungsanordnung um das weitere Datenregister mit Addierwerk und das vorgenannte zwei-

te Datenregister mit Subtrahierwerk folgende Vorteile : Von den mittels des ersten Datenregisters mit Addierwerk gebildeten Impulssummen-Vielfachen (Vielfachperioden) werden mittels des weiteren Datenregisters mit Addierwerk jeweils mehrere aufsummiert, wodurch sich der auf die Einzelperiode bezogene statistische Fehler (Jitter) infolge der entstehenden Mittelwertbildung entsprechend der Quadratwurzel aus der Anzahl der vom zweiten Addierwerk erfaßten Speicherplätze reduziert. Das führt auch in der nachgeschalteten Kombination von Datenregister und Subtrahierwerk zu entsprechend verbesserten Werten für die zeitliche Änderung der mittleren Periodendauer des periodischen Signals.

Es kann zweckmäßig sein, daß an Stelle mehrerer Rechenwerke ein Rechenwerk vorgesehen ist, welches die Differenz- und Summenbildungen zeitlich nacheinander ausführt, wobei die Differenzen und/oder Summen kurzzeitig in Zwischenspeichern abgespeichert werden. Wesentlich bleibt dabei die logische Abfolge der Aufbereitung des periodischen Signals entsprechend dem Signalablauf in den bisher beschriebenen Schaltungsanordnungen.

Schaltungsanordnungen gemäß der Erfindung werden mit besonderem Vorteil in Einrichtungen zur Steuerung, Überwachung und/oder Regelung in Systemen eingesetzt, in denen die Periodendauer oder eine hiervon abgeleitete Größe die Eingangsgröße beziehungsweise die Regelgröße ist, insbesondere in Regelsystemen, die eine große Trägheit beziehungsweise Regelzeitkonstante aufweisen. Derartige Systeme sind beispielsweise automatische Prozeßsteuerungsanlagen, innerhalb derer sich Störimpulse mit Verzögerungen von der Größenordnung Stunden oder Tage ausbreiten. Mittels der erfindungsgemäßen Schaltungsanordnung und den entsprechenden Erweiterungen können dabei sehr geringe Änderungsgeschwindigkeiten des Istwertes selbst bei relativ großer Störspannungsüberlagerung genau erfaßt werden.

Einen Anwendungsfall mit besonders hoher Zeitkonstante stellt beispielsweise das bekannte Gasreibungs-Vakuummeter mit magnetisch aufgehängter Stahlkugel dar, in welchem Änderungsgeschwindigkeiten der Rotationsfrequenz der Kugel von der Größenordnung 10 ppm pro Stunde aufgelöst werden müssen. Dieses Auflösungsvermögen wird bei dem vorgenannten Druckmeßgerät mittels bekannter Vorrichtungen zur Vielfachperiodenmessung in Zeitintervallen von etwa einer Minute erreicht. Bei Verwendung einer Serienschaltung von zwei Datenregistern mit Addierwerk und einem dritten Datenregister mit Subtrahierwerk werden dagegen bei 16 beziehungsweise 17 Speicherplätzen je Datenregister Ergebnisse mit derselben Genauigkeit in Abständen von jeweils einer Sekunde erzielt. Dies ermöglicht einen quasi-kontinuierlichen Betrieb des Gerätes, wodurch sich hierfür ein Einsatz auch in automatischen Gaseinlaß- und Druckregelsystemen eröffnet.

Die Schaltungsanordnung gemäß der Erfindung ist selbstverständlich auch in Systemen mit kürzerer Regelzeitkonstante einsetzbar, da die Ansprechzeit der Schaltungsanordnung im wesentlichen nur durch die Verschiebezeit der Daten sowie durch die Summen- und Differenzbildung nach unten hin begrenzt ist. Da keine höherwertigen Rechenoperationen wie Multiplikationen und Divisionen erforderlich sind, hat die Schaltungsanordnung gemäß der Erfindung eine relativ geringe Grundträgheit. Sie ist daher auch für den Einsatz in elektromechanischen Regelsystemen geeignet, sofern frequenzmodulierte Istwerte zur Verfügung stehen, wie dies beispielsweise bei bekannten Einrichtungen zur berührungslosen Lagerung von Körpern mittels elektrischer oder magnetischer Feldkräfte oder in Drehzahlregelsystemen der Fall ist.

Ausführungsbeispiele der Schaltungsanordnung gemäß der Erfindung sind in der Zeichnung schematisch dargestellt und werden im folgenden näher erläutert :
Es zeigen

Figur 1 eine Schaltungsanordnung mit Zählvorrichtung, Zeittaktgenerator, Datenregister und Addierwerk,

Figur 2 eine Schaltungsanordnung gemäß Figur 1 mit einem als Schieberegister ausgebildeten Datenregister,

Figur 3 eine Schaltungsanordnung gemäß Figur 2 mit einem dem Addierwerk vorgeschalteten Subtrahierwerk,

Figur 4 eine Schaltungsanordnung mit dem Addierwerk nachgeschaltetem zweiten Datenregister mit Subtrahierwerk,

Figur 5 eine Schaltungsanordnung gemäß Figur 4 mit zwischen dem Addierwerk und dem zweiten Datenregister eingeschaltetem weiterem Datenregister mit Addierwerk,

Figur 6 eine Gegenüberstellung von Messungen der mittleren Periodendauer eines periodischen Signals sowie der zeitlichen Änderung der mittleren Periodendauer

a) mittels bekannter Schaltungsanordnungen,

b) mittels einer Schaltungsanordnung mit Datenregister und Addierwerk (untere Kurve) sowie mit nachgeschaltetem zweiten Datenregister und Subtrahierwerk (obere Kurve),

c) mittels einer Schaltungsanordnung mit zwei Datenregistern und abschließendem Addierwerk (untere Kurve) sowie mit drei Datenregistern und abschließendem Subtrahierwerk (obere Kurve).

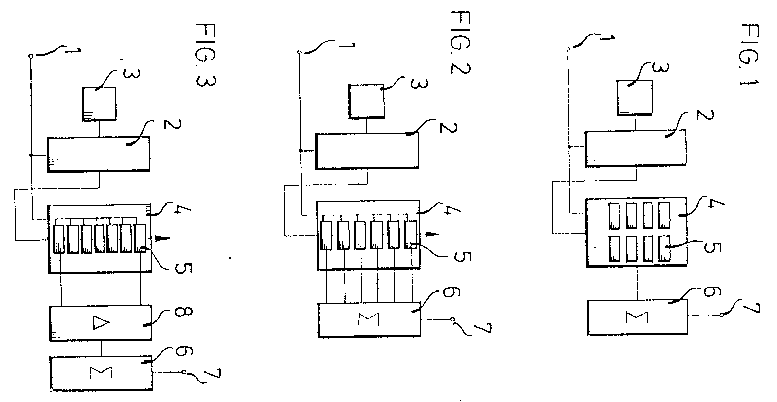

Bei der in Figur 1 wiedergegebenen Schaltungsanordnung wird das periodische Signal an den Befehlstakteingang 1 der Zählvorrichtung 2 geschaltet. Die Zählvorrichtung 2 zählt die Impulse des Zeittaktgenerators 3 und gibt die innerhalb der Befehlstaktintervalle anfallenden Impulssummen an das Datenregister 4 weiter. Die Übertragung der Impulssummen auf die Speicherplätze 5 des Datenregisters 4 wird durch das periodische Signal über den Befehlstakteingang 1 synchronisiert. Das dem Datenre-

gister 4 nachgeschaltete Addierwerk 6 bildet jeweils die Summe einer vorgegebenen Anzahl von aufeinanderfolgend abgespeicherten Impulssummen. Die vom Addierwerk 6 gebildeten Summen stellen jeweils ein der Anzahl der berücksichtigten Speicherplätze 5 entsprechendes Vielfaches der mittleren Periodendauer des periodischen Signals dar, gemessen in den vom Zeittaktgenerator 3 vorgegebenen Zeiteinheiten. Die Ergebnisse stehen am Ausgang 7 des Addierwerkes 6 zur Ausgabe beziehungsweise Weiterverarbeitung an.

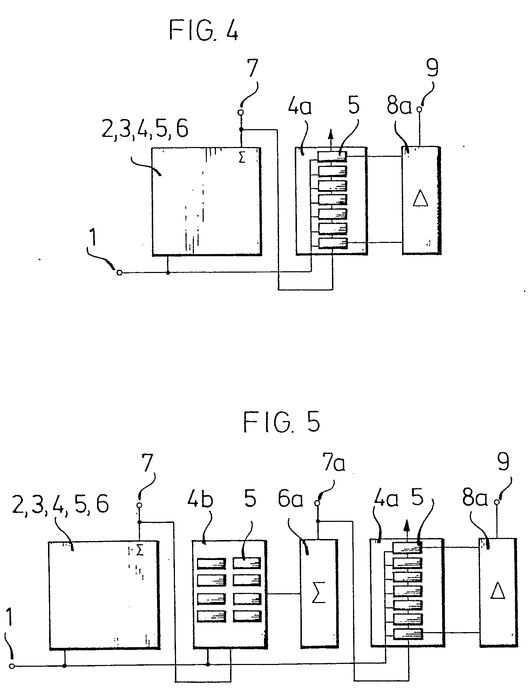

Figur 2 zeigt eine spezielle Ausgestaltung der in Figur 1 wiedergegebenen Schaltungsanordnung, bei der das Datenregister 4 als Schieberegister ausgebildet ist. Das nachgeschaltete Addierwerk 6 bildet jeweils die Summe aus allen auf den Speicherplätzen 5 des Schieberegisters 4 abgespeichertem Impulssummen.

Figur 3 zeigt eine weitere spezielle Ausgestaltung der in Figur 1 wiedergegebenen Schaltungsanordnung, bei der das Datenregister 4 ebenfalls als Schieberegister ausgebildet ist. Die am Ausgabe 7 des Addierwerkes anstehenden Summen entstehen in diesem Falle durch Aufsummierung aller mittels des vorgeschalteten Subtrahierwerkes 8 gebildeten Differenzen zwischen den im ersten und letzten der Speicherplätze 5 des Schieberegisters 4 abgespeichertem Impulssummen.

Figur 4 zeigt eine spezielle Erweiterung der in den vorangehenden Figuren dargestellten Schaltungsanordnung durch ein zusätzliches Datenregister 4a mit Speicherplätzen 5 und abschließendem Subtrahierwerk 8a. Das Subtrahierwerk 8a bildet jeweils die Differenz zwischen den im ersten und letzten der Speicherplätze des Datenregisters 4a abgespeichertem Impulssummen-Vielfachen (Vielfachperioden). Diese Differenzen stellen jeweils ein der Anzahl der berücksichtigten Speicherplätze entsprechendes Vielfaches der zeitlichen Änderung der mittleren Periodendauer des periodischen Signals dar. Die Ergebnisse stehen am Ausgang 9 des Subtrahierwerkes 8a zur Ausgabe beziehungsweise Weiterverarbeitung an.

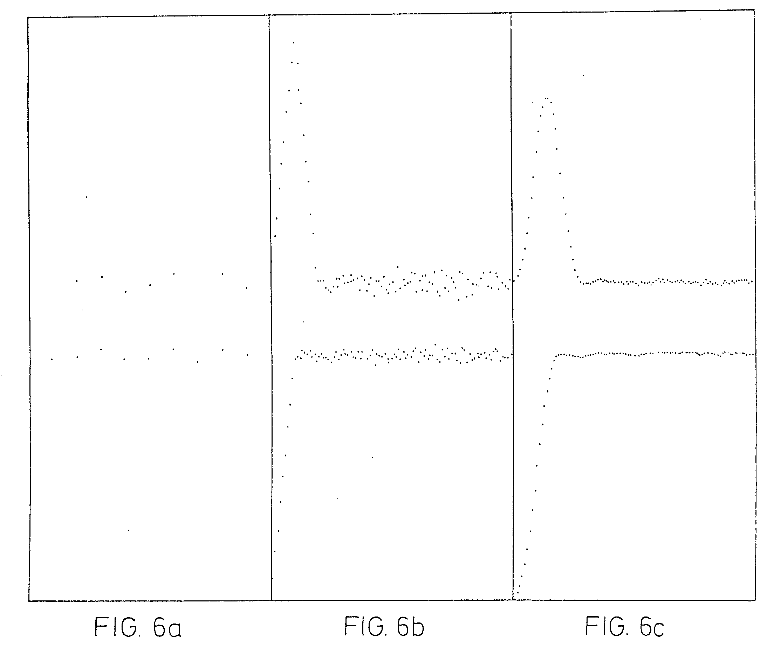

Figur 5 zeigt eine spezielle Erweiterung der in den vorangehenden Figuren dargestellten Schaltungsanordnungen durch ein weiteres Datenregister 4b mit Speicherplätzen 5 und nachgeschaltetem Addierwerk 6a. Die vom Addierwerk 6a gebildeten Summen stellen jeweils ein dem Produkt aus der Anzahl der im Datenregister 4 berücksichtigten Speicherplätze und der Anzahl der im Datenregister 4b berücksichtigten Speicherplätze entsprechendes Vielfaches der mittleren Periodendauer des periodischen Signals dar. Diese Ergebnisse stehen am Ausgang 7a des Addierwerkes 6a zur Ausgabe beziehungsweise Weiterverarbeitung an, von wo aus sie dem Datenregister 4a mit abschließendem Subtrahierwerk 8a zugeleitet werden. Die vom Subtrahierwerk 8a gebildeten Differenzen stellen jeweils ein der Anzahl der berücksichtigten Speicherplätze des Datenregisters 4a entsprechendes Vielfaches der zeitlichen Änderung der mittleren Periodendauer des periodischen Signals dar. Die Ergebnisse stehen am Ausgang 9 der Subtrahierwerke 8a zur Ausgabe beziehungsweise Weiterverarbeitung an.

Figur 6 zeigt im linken Bilddrittel (a) unten eine grafische Darstellung des Verlaufs von mittels bekannter Schaltungen gewonnenen Meßergebnissen der mittleren Periodendauer eines periodischen Signals und, darüber, die zeitliche Änderung der auf diese Weise gewonnenen mittleren Periodendauer. Im mittleren Bilddrittel (b), unten, ist der Verlauf der an den Ausgängen 7 der in den Figuren 1 bis 5 gezeigten Schaltungsanordnungen anstehenden Meßergebnisse für die mittlere Periodendauer des periodischen Signals wiedergegeben. Bei gleicher Gesamtmeßzeit wird an diesen Ausgängen ein der Anzahl der berücksichtigten Speicherplätze im Datenregister 4 entsprechendes Vielfaches (im dargestellten Fall das zehnfache) an Meßergebnissen, bezogen auf die mit bekannten Schaltungen erzielbare Meßwertausbeute, bei unveränderter Streubreite beziehungsweise Standardabweichung der einzelnen Meßwerte gewonnen. Ein bedeuten der Vorteil der erfindungsgemäßen Schaltungsanordnung besteht also in der vergleichsweise hohen Punktauflösung der Meßdiagramme, die insbesondere eine detaillierte Darstellung von raschen zeitlichen Änderungen der mittleren Periodendauer von periodischen Signalen ermöglicht, wie dies aus dem zeitlichen Verlauf der Meßwerte im mittleren (b) und rechten (c) Bilddrittel, am jeweiligen linken Bildrand zu erkennen ist. Die obere Kurve im mittleren Bilddrittel (b) gibt den Verlauf der zeitlichen Änderung der mittleren Periodendauer wieder, wie er am Ausgang 9 der in Figur 4 dargestellten Schaltungsanordnung ansteht. Das rechte Bilddrittel (c) zeigt schließlich den Verlauf der mittleren Periodendauer (untere Kurve), gemessen am Ausgang 7a der in Figur 5 dargestellen Schaltungsanordnung sowie den Verlauf der zeitlichen Änderung der mittleren Periodendauer (obere Kurve), gemessen am Ausgang 9 der Schaltungsanordnung in Figur 5. Ein Vergleich der Kurvenzüge bei (b) und (c) macht deutlich, daß mit der in Figur 5 gezeigten Einschaltung des Datenregisters 4b mit Addierwerk 6a aufgrund der durch diese Komponenten bewirkten Mittelwertbildung gegenüber der Schaltungsanordnung in Figur 4 bei gleich hoher Ausgaberate eine stark reduzierte Streubreite der Meßwerte für die mittlere Periodendauer des periodischen Signals sowie für deren zeitliche Änderung erzielt wird.

## Ansprüche

1. Schaltungsanordnung für die Bestimmung der mittleren Periodendauer eines periodischen Signals, insbesondere eines elektrischen Signals, mit einer im Takt des periodischen Signals freigegebenen oder gestoppten Zählvorrichtung zur Bildung von Impulssummen, wobei die Impulse aus einem frequenzstabilen Zeittaktgenerator stammen, gekennzeichnet durch . ein über einen mit dem periodischen Signal synchronen Befehlstakt von außen steuerbares und zur Aufnahme von Impulssummen vorgesehenes Datenregister (4) mit mindestens zwei Speicherplätzen (5) und ein dem Datenregister nachgeschaltetes Addierwerk (6), welches mit den für die Bildung der Summe vorgesehenen Speicherplätzen des Datenregisters derart in elektrischer Verbindung steht, daß am Ausgang (7) der Schaltungsanordnung jeweils die Summe aus einer vorgegebenen Anzahl von aufeinanderfolgend abgespeicherten Impulssummen zur Verfügung steht.

2. Schaltungsanordnung nach Anspruch 1, dadurch gekennzeichnet, daß die Anzahl der durch die Summenbildung erfaßten Speicherplätze (5) des Datenregisters (4) durch die Zahl 10 teilbar ist.

3. Schaltungsanordnung nach einem der vorangehenden Ansprüche, dadurch gekennzeichnet, daß das Datenregister (4) als Schieberegister ausgebildet ist.

4. Schaltungsanordnung nach einem der vorangehenden Ansprüche, dadurch gekennzeichnet, daß zwischen dem Datenregister (4) und dem Addierwerk (6) ein Subtrahierwerk (8) eingeschaltet ist.

5. Schaltungsanordnung nach einem der vorangehenden Ansprüche, dadurch gekennzeichnet, daß dem Addierwerk (6) ein zweites Datenregister (4a) nachgeschaltet ist mit mindestens drei Speicherplätzen (5) und ein dem zweiten Datenregister (4a) nachgeschaltetes Subtrahierwerk (8a), welches mit dem zweiten Datenregister (4a) derart in elektrischer Verbindung steht, daß am Ausgang (9) des Subtrahierwerkes (8a) jeweils die Differenz zweier nicht aufeinanderfolgend abgespeicherter Summen ansteht.

6. Schaltungsanordnung nach Anspruch 5, dadurch gekennzeichnet, daß das zweite Datenregister (4a) als Schieberegister ausgebildet ist, und das Subtrahierwerk (8a) mit den für die Bildung der Differenz vorgesehenen Speicherplätzen (5) in elektrischer Verbindung steht.

7. Schaltungsanordnung nach einem der Ansprüche 4 bis 6, dadurch gekennzeichnet, daß die Anzahl der Speicherplätze (5) der mit einem Subtrahierwerk (8, 8a) verbundenen Datenregister (4, 4a) Z = N + 1 ist, wobei N durch die Zahl 10 teilbar ist, und daß das jeweilige Subtrahierwerk (8, 8a) mit dem Datenregister (4, 4a) derart verbunden ist, daß es N-1 Speicherplätze (5) überbrückt.

8. Schaltungsanordnung nach einem der vorangehenden Ansprüche, dadurch gekennzeichnet, daß zwischen dem Addierwerk (6) und dem zweiten Datenregister (4a) mindestens ein weiteres Datenregister (4b) mit Addierwerk (6a) vorgesehen ist.

9. Schaltungsanordnung nach einem der Ansprüche 4 bis 8, dadurch gekennzeichnet, daß an Stelle mehrerer Rechenwerke (6, 6a, 8, 8a) ein Rechenwerk vorgesehen ist, welches die Differenz- und Summenbildungen zeitlich nacheinander ausführt, wobei die Differenzen und/oder Summen kurzzeitig in Zwischenspeichern abgespeichert werden.

10. Verwendung einer Schaltungsanordnung nach einem der vorangehenden Ansprüche in Einrichtungen zur Steuerung, Überwachung und/oder Regelung in Systemen, in denen die Periodendauer oder eine hiervon abgeleitete Größe die Eingangsgröße beziehungsweise die Regelgröße ist.

**Claims**

1. Circuit arrangement for determining the mean period of a periodic signal, particularly an electric signal, comprising a counting device, which is released or stopped in time with the periodic signal, for forming pulse totals, wherein the pulses originate from a stable-frequency clock pulse generator, characterised by a data register (4), which is adapted to be controlled from outside by a command clock pulse synchronous with the periodic signal and intended to record pulse totals, and which has at least two storage locations (5), and by an adder (6) which in the circuit follows the data register and is electrically connected to the storage locations provided for forming the total in the data register, in such a manner that at the output (7) of the circuit arrangement the total of a preset number of successively stored pulse totalsis available at any one time.

2. Circuit arrangement according to Claim 1, characterised in that the number of storage locations (5) in the data register (4) which are concerned with the totalisation is divisible by 10.

3. Circuit arrangement according to one of the preceding claims, characterised in that the data register (4) is in the form of a shift register.

4. Circuit arrangement according to one of the preceding claims, characterised in that a subtracter (8) is inserted between the data register (4) and the adder (6).

5. Circuit arrangement according to one of the preceding claims, characterised in that a second data register (4a) follows the adder (6) in the circuit and has at least three storage locations (5) and that the second data register (4a) is followed in the circuit by a subtracter (8a) which is electrically connected to the second data register (4a) in such a manner that at the output (9) of the subtracter (8a) the difference between two totals not stored in succession occurs at any one time.

6. Circuit arrangement according to Claim 5, characterised in that the second data register (4a) is in the form of a shift register and the subtracter (8a) is electrically connected to the storage locations (5) provided for forming the difference.

7. Circuit arrangement according to one of Claims 4 to 6, characterised in that the number of storage locations (5) of the data registers (4, 4a) connected to a subtracter (8, 8a) is Z = N + 1, in which N is divisible by 10, and that the respective subtracter (8, 8a) is connected to the data register (4, 4a) in such a manner that it bridges over N-1 storage locations (5).

8. Circuit arrangement according to one of the preceding claims, characterised in that at least one additional data register (4b) with an adder (6a) is provided between the adder (6) and the second data register (4a).

9. Circuit arrangement according to one of Claims 4 to 8, characterised in that instead of a plurality of arithmetic units (6, 6a, 8, 8a) one arithmetic unit is provided which forms the differences and the totals chronologically one after the other, the differences and/or totals being briefly stored in intermediate stores.

10. The use of a circuit arrangement according to one of the preceding claims in devices for control, monitoring, and/or closed-loop control in systems in which the period or a parameter derived therefrom is the input value or controlled variable.

**Revendications**

1. Montage pour déterminer la durée moyenne de la période d'un signal périodique, en particulier d'un signal électrique, avec un dispositif de comptage libéré ou arrêté à la cadence du signal périodique pour former des sommes d'impulsions des impulsions provenant d'un générateur de cadence de fréquence stable, caractérisé par un registre de données (4) commandé de l'extérieur par l'intermédiaire d'une cadence d'instruction synchrone avec le signal périodique et prévu pour recevoir des sommes d'impulsions, ledit registre de données ayant au moins deux emplacements de mémoire (5), et par un dispositif additionneur (6) monté en aval du registre de données et relié électriquement de telle façon avec les emplacements de mémoire prévus pour la formation de la somme, qu'à la sortie (7) est disponible la somme d'un nombre prédéterminé de sommes d'impulsions mémorisées successivement.

2. Montage selon la revendication 1, caractérisé par le fait que le nombre des emplacements de mémoire (5) du registre de données (4), qui sont saisis par la formation de la somme, est divisible par le nombre 10.

3. Montage selon l'une des revendications précédentes, caractérisé par le fait que le registre de données (4) est réalisé sous la forme d'un registre à décalage.

4. Montage selon l'une des revendications précédentes, caractérisé par le fait qu'entre le registre de données (4) et le dispositif additionneur (6) est monté un dispositif de soustraction (8).

5. Montage selon l'une des revendications précédentes, caractérisé par le fait qu'en aval du dispositif additionneur (6) est monté un second registre de données (4a) avec au moins trois emplacements de mémoire (5) et un dispositif de soustraction (8a) monté en aval du second registre de données (4a), et qui est relié de telle manière au second registre de données (4a) qu'à la sortie (9) du dispositif de soustraction (8a) est présente la différence entre deux sommes mémorisées qui ne se suivent pas.

6. Montage selon la revendication 5, caractérisé par le fait que le second registre de données (4a) est réalisé sous la forme d'un registre à décalage, et que le dispositif de soustraction (8a) est relié électriquement avec les emplacements de mémoire (5) qui sont prévus pour la formation de la différence.

7. Montage selon l'une des revendications 4 à 6, caractérisé par le fait que le nombre d'emplacements de mémoire (5) des registres de données (4, 4a) qui sont reliés à un dispositif de soustraction (8, 8a) est Z = N + 1, N étant divisible par le nombre 10, et que le dispositif de soustraction concerné (8, 8a) est relié de telle façon au registre de données (4, 4a) qu'il ponte N-1 emplacements de mémoire (5).

8. Montage selon l'une des revendications précédentes, caractérisé par le fait qu'entre le dispositif additionneur (6) et le second registre de données (4a), il est prévu au moins un registre de données supplémentaire (4b) avec dispositif additionneur (6a).

9. Montage selon l'une des revendications 4 à 8, caractérisé par le fait qu'à la place de plusieurs unités de calcul (6, 6a, 8, 8a) il est prévu une unité de calcul qui réalise successivement dans le temps les formations de la différence et de la somme, les différences et/ou les sommes étant mémorisées pour une courte durée dans des mémoires intermédiaires.

10. Montage selon l'une des revendications précédentes dans un dispositif pour la commande, la surveillance et/ou le réglage de systèmes dans lesquels la durée de la période où une grandeur qui en est dérivée, est la grandeur d'entrée ou la grandeur de réglage.

FIG. 1

FIG. 2

FIG. 3

## FIG. 4

## FIG. 5

2

FIG. 6a   FIG. 6b   FIG. 6c